# EUROPEAN PATENT APPLICATION

(11) **EP 4 611 043 A1**
(43) Date of publication of application: **03.09.2025**
(21) Application number: 23914431.4
(22) Date of filing: 27.11.2023
(51) Int. Cl.: H01L 27/15, H01L 33/00, H01L 33/44, H01L 33/52

(54) **DISPLAY MODULE MANUFACTURING METHOD, DISPLAY MODULE AND REPAIR METHOD**

(30) Priority: 05.01.2023 CN 202310023051
(71) Applicant: HCP Technology Co., Ltd., Guangdong 523000 (CN)
(72) Inventor: HUNG, Wenchen, Dongguan, Guangdong 523000 (CN); HUANG, Chih-chiang, Dongguan, Guangdong 523000 (CN); LI, Chao, Dongguan, Guangdong 523000 (CN); YE, Runjian, Dongguan, Guangdong 523000 (CN); YOU, Yuan, Dongguan, Guangdong 523000 (CN); HONG, Xiaofang, Dongguan, Guangdong 523000 (CN)
(74) Representative: Meyer, Thorsten
(86) International application number: PCT/CN2023/134214
(87) International publication number: WO 2024/146297

(57) **Abstract**

A display module manufacturing method, comprising: step I, providing a substrate with several light-emitting chips mounted on a front surface thereof; step II, spray-coating the substrate with a thin-film-shaped protective material, and curing the thin-film-shaped protective material to form a thin-film protective layer attached to the front surface of the substrate and front and side faces of the light-emitting chips; and step III, providing a protective membrane with a soft adhesive layer as a bottom layer thereof, attaching the protective membrane to the front surface of the substrate by means of the soft adhesive layer, filling with the soft adhesive layer a gap between adjacent light-emitting chips, and curing the soft adhesive layer to form a filled layer. Further disclosed in the present application are a corresponding display module, and a repair method for the display module. Compared with the prior art, the present application involves convenient packaging and high production efficiency; a packaged display module is easily repaired, and the repaired display module has good surface ink color consistency.

## Description

### FIELD OF THE INVENTION

The present application relates to the manufacturing of display modules, and particularly to the packaging and repair of the display modules.

### BACKGROUND OF THE INVENTION

Mini/Micro LED displays are currently a mainstream next-generation small-pitch high-definition display technology, widely used in applications such as command centers, conference rooms, security monitoring, and large-screen home TVs. Mini/Micro LED displays are assembled by tiling multiple Mini/Micro LED display modules.

A Mini/Micro LED display module is constructed by mounting RGB Mini/Micro LED chips (hereinafter referred to as "LED chips") on one surface of a circuit substrate and controlling the display via driver ICs on the opposite surface. After the LED chips are fixed, an encapsulation layer is typically formed on their surface. This encapsulation layer protects the LED chips from direct mechanical impact and prevents moisture/oxygen exposure that could cause short-circuit damage. Conventionally, the encapsulation layer is formed by applying epoxy-based encapsulant material over the LED chip array and then pressing it into a flat surface. However, this encapsulation method has drawbacks. Since the encapsulation layer is a monolithic structure, repairing a faulty LED chip requires digging out the encapsulant, replacing the defective chip, reapplying encapsulant, and flattening the surface. This process inevitably affects the ink color uniformity of the encapsulation layer. Alternatively, completely removing the encapsulation layer risks damaging functional LED chips and incurs high repair costs.

Therefore, there is an urgent need for a manufacturing method for a display module, a display module, and a repair method to address these issues.

### SUMMARY OF THE INVENTION

The objective of the present application is to provide a manufacturing method for a display module and display module that facilitate repair while maintaining excellent ink color uniformity on the surface of the display module.

To achieve the above objective, the present invention provides a manufacturing method for a display module including Step I: providing a substrate with a plurality of light-emitting chips mounted on a front surface thereof; Step II: spraying the substrate with a thin-film protective material, and curing the thin-film protective material to form a thin-film protective layer adhered to the front surface of the substrate, as well as front and side surfaces of the light-emitting chips; and Step III: providing a protective film with a soft adhesive layer as a bottom layer thereof, attaching the protective film to the front surface of the substrate via the soft adhesive layer, filling gaps between adjacent light-emitting chips with the soft adhesive layer, and curing the soft adhesive layer to form a filling layer.

Preferably, the substrate includes a PCB substrate or a glass substrate.

Preferably, the thin-film protective material comprises an adhesive material and a diluent uniformly mixed together, and a ratio of the adhesive material to the diluent is 1:3 to 3:5.

Preferably, the adhesive material is one or more of epoxy resin, silicone resin, acrylic resin, and polyurethane, and the thin-film protective material further comprises silica material.

Preferably, the thin-film protective material further contains silica material, which achieves a more uniform spraying effect.

Preferably, a thickness of the thin-film protective material is 15-40 µm, more preferably 20µm.

Preferably, the soft adhesive layer is an optically clear adhesive (OCA) layer, and a thickness of the soft adhesive layer is ≥ 100 µm.

Preferably, the thickness of the soft adhesive layer is 150 µm, and the thickness may be reduced or increased based on the dimensions of the light-emitting chips.

Preferably, between Step II and Step III, the manufacturing method further includes performing an aging treatment on the substrate and the light-emitting chips mounted thereon.

Preferably, the protective film further includes an ink layer formed on the soft adhesive layer, and a transparent layer formed on the ink layer.

Preferably, the transparent layer is a PET transparent layer.

Preferably, the protective film further includes an AG (Anti-Glare) layer, an AR (Anti-Reflection) layer, or an AF (Anti-Fingerprint) layer.

Preferably, the soft adhesive layer is mixed with a diffuser powder material to help to convert point light spots of the light-emitting chips into planar light spots.

Preferably, the diffuser powder material includes silica.

The present application further discloses a display module, including a substrate; a plurality of light-emitting chips mounted on a front surface of the substrate; a thin-film protective layer covering the front surface of the substrate, as well as front and side surfaces of the light-emitting chips; and a protective film adhered to the front surface of the substrate and the light-emitting chips, wherein a bottom layer of the protective film is a soft adhesive layer, and the soft adhesive layer is filled in gaps between adjacent light-emitting chips and cured to form a filling layer.

Preferably, the protective film further includes an ink layer formed on the soft adhesive layer, and a transparent layer formed on the ink layer.

Preferably, the transparent layer is a PET transparent layer.

Preferably, the protective film further includes a functional layer formed on the transparent layer, which may be an AG (Anti-Glare) layer, an AR (Anti-Reflection) layer, or an AF (Anti-Fingerprint) layer.

Preferably, the soft adhesive layer is mixed with a diffuser powder material to help to convert point light spots of the light-emitting chips into planar light spots. Preferably, the diffuser powder material includes silica.

Preferably, the display module is manufactured by the above manufacturing method.

The present application further discloses a repair method for a display module, being used to repair the display module mentioned above. The repair method includes determining a faulty position of a defective light-emitting chip; peeling off the protective film; breaking the thin-film protective layer at the faulty position and removing the defective light-emitting chip; reinstalling a light-emitting chip at the faulty position; spraying and curing a thin-film protective material at the faulty position to repair the thin-film protective layer; and reattaching a new protective film to the front surface of the substrate, filling gaps between adjacent light-emitting chips with the soft adhesive layer, and curing the soft adhesive layer to form a filling layer.

Compared with the prior art, the display module of the present application employs a protective film with a soft adhesive layer as its base, which is applied to the front surface of the substrate to fill gaps between light-emitting chips to form a protective structure. This eliminates the need for traditional encapsulant materials, simplifying the packaging process and improving production efficiency. During the repair of the display module, there is no need to break open an encapsulation layer, simply peeling off the protective film. The repair process also avoids the requirement of refilling encapsulant, ensuring the repaired display module retains a uniform thin-film protective layer on its surface with consistent ink coloration. Furthermore, in the present application, a thin-film protective layer fully covers both the light-emitting chips and the front surface of the substrate. This creates a protective barrier over the chips, where the cured thin-film layer exhibits superior sealing and thermal conductivity properties. It effectively prevents direct exposure of the light-emitting chips to atmospheric moisture or oxygen. In cases where LED display modules require repair, the thin-film protective layer safeguards the chips during film removal, preventing damage or peeling due to peeling forces. After replacing defective chips, a new film can be reattached effortlessly. This method streamlines the repairs while preventing impact on other light-emitting chips.

### BRIEF DESCRIPTION OF THE DRAWINGS

The accompanying drawings facilitate an understanding of the various embodiments of this invention. In such drawings:
FIG. 1 is a flowchart of the manufacturing method of a display module according to the present application;
FIG. 2 is a process schematic diagram of the manufacturing method of the display module according to the present application.
FIG. 3a is a structural diagram of the protective film according to a preferred embodiment of the present application;
FIG. 3b is a structural diagram of the protective film according to another embodiment of the present application;
FIG. 4 is a structural diagram of the display module according to the present application; and
FIG. 5 is a workflow of the repair method of the display module according to the present application.

### DETAILED DESCRIPTION OF ILLUSTRATED EMBODIMENTS

To elaborate on the technical content, structural features, and the effects achieved, the present invention will be described in detail below with reference to the accompanying drawings and preferred embodiments.

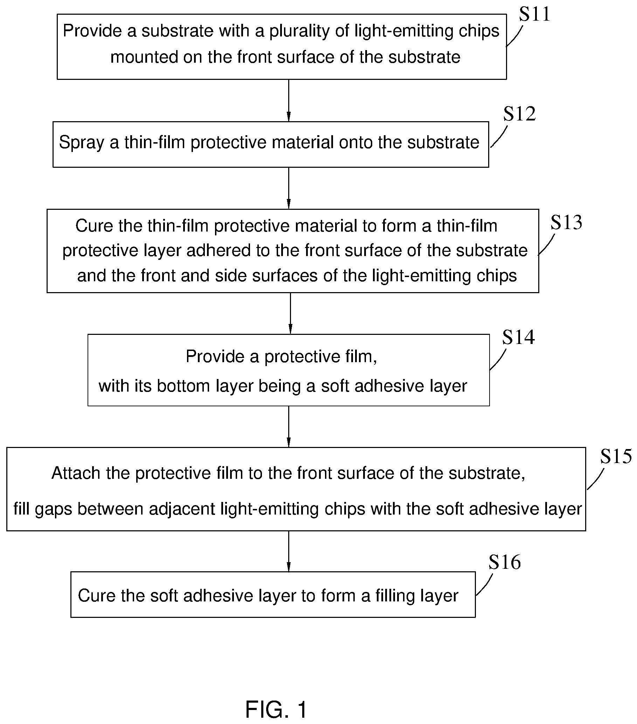

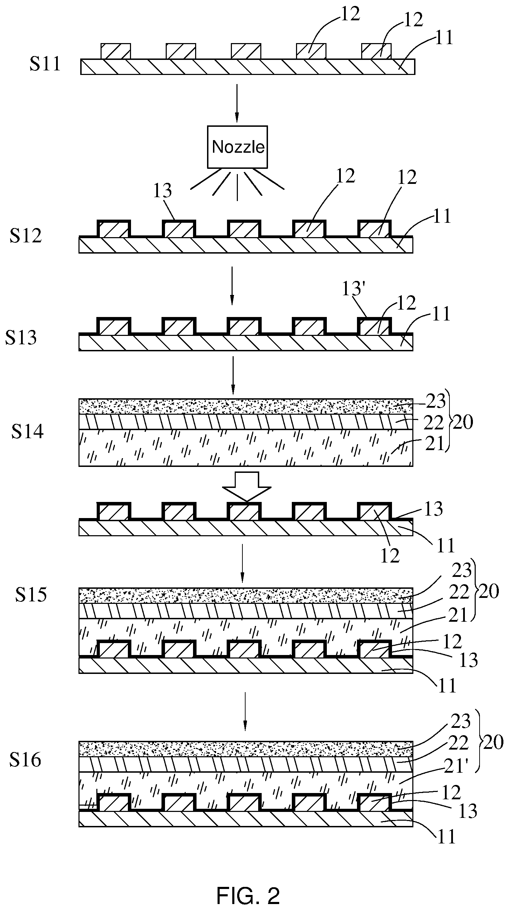

Referring to FIGs. 1 and 2, the present application discloses a manufacturing method for a display module, including steps S11 to S16.

Step S11, provide a substrate 11, with a plurality of light-emitting chips 12 mounted on the front surface of the substrate 11. In this embodiment, the light-emitting chips 12 are LEDs. The back surface of the substrate 11 is also equipped with a driver IC for driving the light-emitting chips 12 on the front surface. The substrate may be a PCB substrate, glass substrate, etc.

In this embodiment, the light-emitting chips 12 are transferred to the front surface of the substrate 11 by a Pick & Place process or a mass transfer process and are fixed onto the front-side pads by reflow soldering or laser soldering. The driver IC is fixed to the back surface of the substrate 11 by an SMT (Surface Mount Technology) process.

Step S12, spray a thin-film protective material onto the substrate 11. The thin-film protective material encapsulates the front surface of the substrate 11, as well as the front and side surfaces of the light-emitting chips 12, thereby protecting the front surface of the substrate 11 and the light-emitting chips 12.

Specifically, the thin-film protective material 13 includes an adhesive material and a diluent uniformly mixed together. Specifically, the ratio of adhesive material to diluent ranges from 1:3 to 3:5. The diluent ensures sufficient fluidity of the adhesive material within the nozzle. During the spraying process (from nozzle ejection to deposition on the light-emitting chips 12 and the front surface of the substrate 11), the diluent is volatilized in the air. By the time the adhesive material is sprayed on the surface of the light-emitting chips 12, its fluidity is significantly reduced, allowing it to adhere to the surface and form the protective layer shape shown in Step S12 of FIG. 2.

Specifically, the thickness of the sprayed thin-film protective material 13 is controlled by adjusting the distance between the nozzle and the substrate 11 and the feeding pressure during spraying. In this embodiment, the distance from the nozzle to the substrate 11 ranges from 1 to 5 cm, and the feeding pressure ranges from 2 to 5 atm. The thickness of the sprayed thin-film protective material 13 is 15 - 40 µm, preferably 20 µm.

Specifically, the adhesive material may be one or more of epoxy resin, silicone resin, acrylic resin, and polyurethane.

Preferably, the thin-film protective material 13 further contains silica material, which achieves a more uniform spraying effect.

Step S13, cure the thin-film protective material 13 to form a thin-film protective layer 13' adhered to the front surface of the substrate 11 and the front and side surfaces of the light-emitting chips 12.

Specifically, the function of the thin-film protective layer 13' is to form a protective coating on the surface of the light-emitting chips 12. The cured thin-film protective layer 13' exhibits strong sealing and thermal conductivity properties, preventing direct contact between the light-emitting chips 12 and moisture/oxygen in the air. If the display module requires repair, when the protective film 20 is peeled off, the thin-film protective layer 13' safeguards the light-emitting chips 12, thereby preventing damage or detachment during the peeling process. Subsequently, the damaged light-emitting chips 12 can be repaired, and a new protective film 20 can be reapplied.

In this embodiment, the thin-film protective material 13 is cured via baking, to form the thin-film protective layer 13'. In this embodiment, the baking temperature ranges from 100 - 130°C, and the duration is 10 - 30 minutes. The heat curing enhances the bonding strength between the thin-film protective layer 13' and the light-emitting chips 12 as well as the substrate 11.

Step S14, provide a protective film 20, wherein the bottom layer of the protective film 20 is a soft adhesive layer 21.

In this embodiment, the soft adhesive layer 21 is an OCA (Optically Clear Adhesive) layer. Alternatively, other elastic adhesive materials may be used, not limited to OCA.

Referring to FIG. 2, the protective film 20 further includes a PET transparent layer 22 formed on the soft adhesive layer 21 and an ink layer 23 formed on the PET transparent layer.

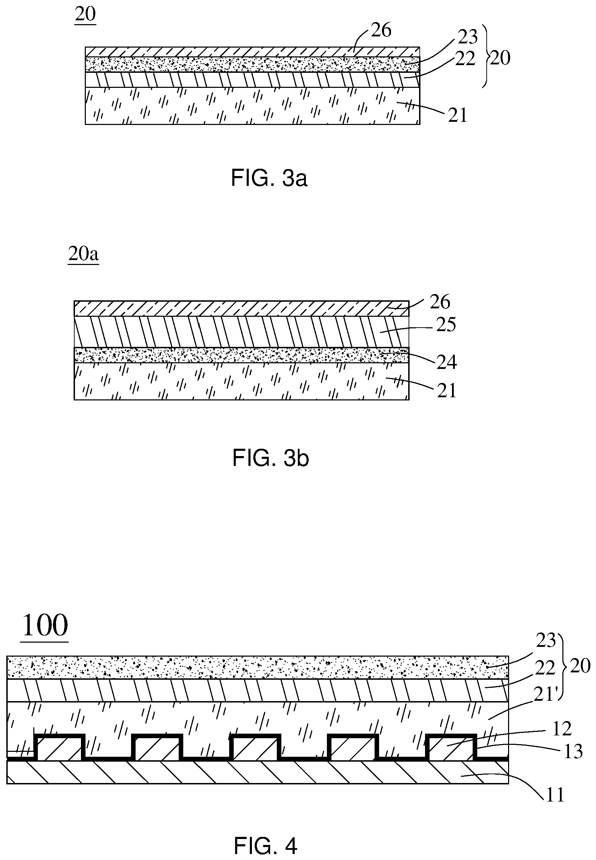

Preferably, as shown in FIG. 3a, the protective film 20 further includes a functional layer 26 formed on the ink layer 23. The functional layer 26 may be an AG (Anti-Glare) layer for example a film or a glass layer, AR (Anti-Reflection), or AF (Anti-Fingerprint) layer for example a film or a glass layer.

Referring to FIG. 3b, in another embodiment, the protective film 20a includes a carbon black layer 24 formed on the soft adhesive layer 21 and a PET transparent layer 25 formed on the carbon black layer 24. Other ink materials may replace the carbon black layer 24, not limited to carbon black materials; and other transparent insulating materials may substitute the PET transparent layer 25, not limited to PET materials

Preferably, the protective film 20a further includes a functional layer 26 on the PET transparent layer 25. The functional layer 26 may be an AG, AR, or AF layer.

Preferably, the soft adhesive layer 21 may contain diffuser powder material to help convert point light sources from the light-emitting chips into uniform surface illumination. Specifically, the diffuser powder material may be silica.

Step S15, attach the protective film 20 to the front surface of the substrate 11, and fill the gaps between adjacent light-emitting chips 12 with the soft adhesive layer 21.

Specifically, the thickness of the soft adhesive layer 21 is ≥100 µm, preferably 150 µm. Optionally, the thickness of the soft adhesive layer 21 may be reduced or increased based on the dimensions of the light-emitting chips 12.

Step S16, cure the soft adhesive layer 21 to form a filling layer 21'.

In this embodiment, the curing of the soft adhesive layer 21 involves baking at 70 - 80°C for 3 - 5 minutes, followed by UV irradiation to cure, so as to enhance adhesion between the soft adhesive layer 21 and the thin-film protective layer 13'.

It should be noted that, the bonding strength between the thin-film protective layer 13' and the light-emitting chips 12 and the substrate 11 is greater than that between the thin-film protective layer 13' and the soft adhesive layer 21. This ensures that during repair, peeling the protective film 20 only separates the soft adhesive layer 21, leaving the thin-film protective layer 13' intact on the light-emitting chips 12 and substrate 11.

Preferably, a step of aging treatment is further included between Steps S13 and S15, for processing the substrate 11 and the light-emitting chips 12.

In this embodiment, in the aging treatment, the substrate 11 and the light-emitting chips 12 are powered under 45 - 55°C ambient temperature (preferably 50°C) until the front surface of the substrate 11 reaches 70°C, lasting 48 hours.

Referring FIG. 4, the present application further discloses a display module 100 manufactured via the above method. The display module 100 includes a substrate 11, a plurality of light-emitting chips 12 mounted on a front surface of the substrate 11, a thin-film protective layer 13' covering the front surface of the substrate 11, as well as the front and side surfaces of the light-emitting chips 12, and a protective film 20 adhered to the front surface of the substrate and the light-emitting chips 12. A bottom layer of the protective film 20 is a soft adhesive layer 21, and the soft adhesive layer 21 is filled in gaps between adjacent light-emitting chips 12 and cured to form a filling layer 21'.

Compared with the prior art, the surface of the light-emitting chips 12 in the present application is sealed and protected by a film lamination method, which effectively improves production efficiency and simplifies the repair over traditional compression molding encapsulation. Furthermore, a thin protective layer 13' is formed on both the substrate 11 and the light-emitting chips 12 by spraying coating, which enhances the sealing performance of the film lamination process while simultaneously providing reliable protection for the light-emitting chips during protective film 20 removal in display module maintenance. This integrated solution substantially improves operational feasibility in manufacturing processes and reduces material wastage, effectively preventing potential damage or detachment of components during film removal operations.

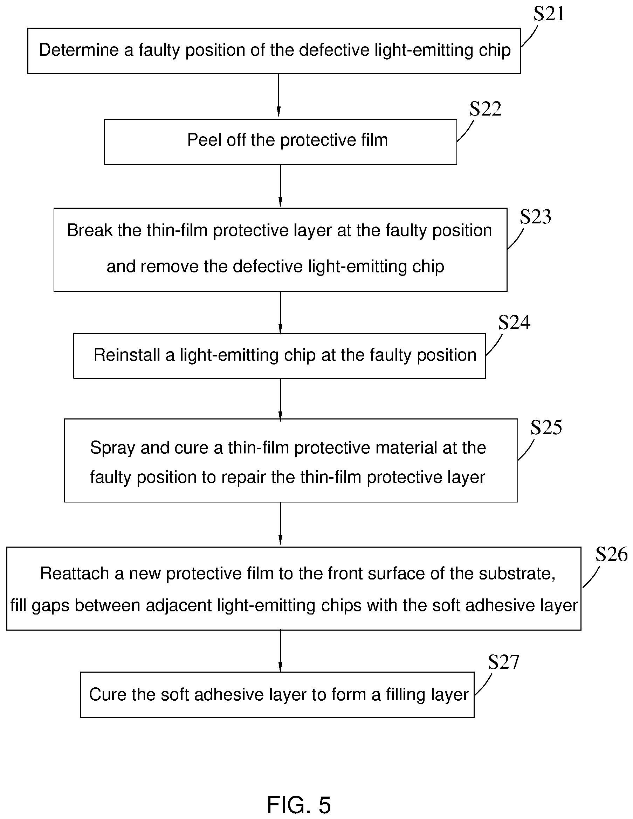

Referring to FIG. 5, the present application also discloses a repair method for a display module for repairing the display module 100 as described above. The display module repair method includes steps S21 to S27.

Step S21, determine a faulty position of the defective light-emitting chip 12.

Step S22: peel off the protective film 20. At this stage, the thin-film protective layer 13' remains intact.

Step S23, break the thin-film protective layer 13' at the faulty position and remove the defective light-emitting chip 12. In this embodiment, the thin-film protective layer 13' at the faulty position may be directly cut, or a laser may be used to remove part of the material of the thin-film protective layer 13' along the boundary line of the faulty position to expose the pads of the defective light-emitting chip 12. The pads are then heated to melt the solder, after which the defective light-emitting chip 12 is removed.

Step S24, reinstall a light-emitting chip 12 at the faulty position. In this embodiment, solder is replenished according to the remaining solder on the pads, or excess solder is removed to ensure the amount of solder on the pads falls within a preset range. A qualified light-emitting chip 12 is then installed at the original pad position.

Step S25, spray and cure a thin-film protective material 13 at the faulty position to repair the thin-film protective layer 13'.

Step S26, reattach a new protective film 20 to the front surface of the substrate 11, and fill the gaps between adjacent light-emitting chips 12 with the soft adhesive layer 21.

Step S27, cure the soft adhesive layer 21 to form a filling layer 21'.

The above disclosure is merely a preferred embodiment of the present application and certainly does not limit the scope of rights of this application. Therefore, equivalent modifications made within the scope of the claims of this application shall still fall within the coverage of this application.

## Claims

1. A manufacturing method for a display module, comprising:
Step I: providing a substrate with a plurality of light-emitting chips mounted on a front surface thereof;
Step II: spraying the substrate with a thin-film protective material, and curing the thin-film protective material to form a thin-film protective layer adhered to the front surface of the substrate, as well as front and side surfaces of the light-emitting chips; and
Step III: providing a protective film with a soft adhesive layer as a bottom layer thereof, attaching the protective film to the front surface of the substrate via the soft adhesive layer, filling gaps between adjacent light-emitting chips with the soft adhesive layer, and curing the soft adhesive layer to form a filling layer.

2. The manufacturing method for a display module according to claim 1, wherein the thin-film protective material comprises an adhesive material and a diluent uniformly mixed together, and a ratio of the adhesive material to the diluent is 1:3 to 3:5.

3. The manufacturing method for a display module according to claim 2, wherein the adhesive material is one or more of epoxy resin, silicone resin, acrylic resin, and polyurethane, and the thin-film protective material further comprises silica material.

4. The manufacturing method for a display module according to claim 1, wherein a thickness of the thin-film protective material is 15-40 µm.

5. The manufacturing method for a display module according to claim 1, wherein the soft adhesive layer is an optically clear adhesive (OCA) layer, and a thickness of the soft adhesive layer is ≥ 100 µm.

6. The manufacturing method for a display module according to claim 1, wherein between Step II and Step III, the manufacturing method further comprises: performing an aging treatment on the substrate and the light-emitting chips mounted thereon.

7. The manufacturing method for a display module according to claim 1, wherein the soft adhesive layer is mixed with a diffuser powder material.

8. A display module, comprising:
a substrate;
a plurality of light-emitting chips mounted on a front surface of the substrate;
a thin-film protective layer covering the front surface of the substrate, as well as front and side surfaces of the light-emitting chips; and
a protective film adhered to the front surface of the substrate and the light-emitting chips, wherein a bottom layer of the protective film is a soft adhesive layer, and the soft adhesive layer is filled in gaps between adjacent light-emitting chips and cured to form a filling layer.

9. The display module according to claim 8, wherein the display module is manufactured by the manufacturing method for a display module according to any one of claims 1-7.

10. A repair method for a display module, being used to repair the display module according to claim 8, the repair method comprising:
determining a faulty position of a defective light-emitting chip;
peeling off the protective film;
breaking the thin-film protective layer at the faulty position and removing the defective light-emitting chip;
reinstalling a light-emitting chip at the faulty position;
spraying and curing a thin-film protective material at the faulty position to repair the thin-film protective layer; and
reattaching a new protective film to the front surface of the substrate, filling gaps between adjacent light-emitting chips with the soft adhesive layer, and curing the soft adhesive layer to form a filling layer.
